# EUROPÄISCHE PATENTANMELDUNG

(11) **EP 1 566 851 A2**
(43) Veröffentlichungstag der Anmeldung: **24.08.2005**
(21) Anmeldenummer: 04029657.6
(22) Anmeldetag: 15.12.2004
(51) Int. Cl.: H01L 41/047, G01F 23/296

(54) **Mehrfachelektrode für eine Schwingungserzeugungs- und/oder Schwingungserfassungsvorrichtung**

(30) Priorität: 18.02.2004 DE 102004007767
(71) Anmelder: VEGA Grieshaber KG, 77709 Wolfach (DE)
(72) Erfinder: Ohmayer, Gerd, 77716 Haslach (DE); Dietmeier, Jürgen, 77758 Hausach (DE)
(74) Vertreter: Patentanwälte Westphal, Mussgnug & Partner

(57) **Zusammenfassung**

Die Erfindung bezieht sich auf eine Mehrfachelektrode für eine Schwingungserzeugungs- und/oder Schwingungserfassungsvorrichtung (1) mit zumindest zwei Elektroden (5,6;5*,6*) und einem diese verbindenden Verbindungsleiter (14;25,26), wobei die beiden Elektroden (5,6;5*,6*) parallel mit einem Abstand (h) zueinander angeordnet sind.

Vorteilhaft ausgebildet wird die Mehrfachelektrode dadurch, dass die beiden Elektroden (5,6;5*,6*) und der Verbindungsleiter (14;25,26) aus einem einteiligen Metallabschnitt ausgebildet sind.

## Beschreibung

Die Erfindung bezieht sich auf eine Mehrfachelektrode für eine Schwingungserzeugungs- und/oder Schwingungserfassungsvorrichtung mit den oberbegrifflichen Merkmalen des Patentanspruchs 1, eine Schwingungserzeugungs- und/oder Schwingungserfassungsvorrichtung mit einer solchen Mehrfachelektrode bzw. auf ein Verfahren zum Herstellen einer solchen Mehrfachelektrode.

WO 01/84642 A1 offenbart ein piezokeramisches Mehrschichtbauteil für Messgeräte sowie dessen Herstellungsverfahren. Das Mehrschichtbauteil besteht aus einer Vielzahl von parallel zueinander angeordneten piezokeramischen Elementen als scheibenförmig übereinander gestapelten Schwingungselementen. In der Oberfläche eines jeden dieser Schwingungselemente ist eine Elektrode zur Kontaktierung integriert. Jeweils zwei parallel zueinander angeordnete Elektroden eines ersten, dritten und fünften Schwingungselements sind über separate Verbindungsleiter miteinander verbunden. Ebenso sind die Elektroden des dazwischen liegenden zweiten und vierten Schwingungselements über einen Verbindungsleiter miteinander verbunden. Bekannt ist somit eine Anordnung, bei der die Schwingungselemente jeweils eine oberseitige, flächige Elektrodenschicht aufweisen, wobei die Elektrodenschichten mehrerer gleichpoliger Elektroden über separate Verbindungleiter miteinander verbunden werden. Zum Verbinden werden dabei durch den Stapel aus Schwingungselementen U-förmig gebogene Verbindungsleiter als separate Bauelemente eingelegt. Einzelne solcher Verbindungsleiter, welche auf gleiches Potential zu legen sind, werden dabei über beispielsweise ein Print miteinander durch Löten verbunden.

Eine solche Anordnung übereinander gestapelter Schwingungselemente ist aufgrund der großen Anzahl von Einzelbauteilen nachteilhaft. Zusätzlich zu den Schwingungselementen mit den stirnseitigen Elektrodenschichten müssen separate Verbindungsleiter bereitgestellt werden. Zum Einlegen der Verbindungsleiter in den Stapel aus Schwingungselementen sind entsprechende Nuten in den Elektrodenschichten auszubilden. Außerdem sind zum Verbinden von mehr als zwei auf gleiches Potential zu legenden Elektroden zusätzliche Verbindungsleiter bereitzustellen, welche zusätzlich miteinander zu verbinden sind. Ein solches Mehrschichtbauteil mit untereinander verlöteten Elektroden und Verbindungsleitern oder Verbindungsleitern untereinander ist außerdem nur bei niedrigen Umgebungstemperaturen einsetzbar, da ansonsten das Lot verflüssigen würde.

Die Aufgabe der Erfindung besteht darin, eine Mehrfachelektrode für eine Schwingungserzeugungs- und/oder Schwingungserfassungsvorrichtung mit Blick auf die Anzahl erforderlicher Einzelelemente und ein vereinfachtes Herstellungsverfahren zu verbessern.

Diese Aufgabe wird durch eine Mehrfachelektrode für eine Schwingungserzeugungs- und/oder Schwingungserfassungsvorrichtung mit den Merkmalen des Patentanspruchs 1 bzw. durch ein Verfahren zum Herstellen einer solchen Mehrfachelektrode mit den Merkmalen des Patentanspruchs 14 gelöst.

Die besonders bevorzugte Ausführungsform bezieht sich somit auf eine Mehrfachelektrode für eine Schwingungserzeugungs- und/oder Schwingungserfassungsvorrichtung mit zumindest zwei Elektroden und einem diese verbindenden Verbindungsleiter, wobei die beiden Elektroden parallel mit einem Abstand zueinander angeordnet sind und wobei die beiden Elektroden und der Verbindungsleiter aus einem einteiligen Metallabschnitt ausgebildet sind. Eine solche einfach ausgebildete Mehrfachelektrode bietet eine Vielzahl von Vorteilen. Anstelle beliebig viele Einzelelektroden bereitzustellen oder direkt an den Schwingungselementen auszubilden und zusätzlich eine Vielzahl einzelner Verbindungselemente bereitzustellen, muss nur noch ein einziges Bauteil angefertigt und gehandhabt werden. Dies ermöglicht zugleich einen einfachen Anschluss an eine Antriebsleitung bzw. an ein Kabel durch Verpressen, Krimpen oder Schweißen. Neben Umweltfreundlichkeit durch entfallendes Anlöten ist auch der Einsatz bei sehr hohen Temperaturen möglich, bei welchen Lot verflüssigen würde. Prinzipiell kann eine beliebige Vielzahl von Elektroden mit jeweils einem dazwischen angeordneten Verbindungsleiter in Folge einstückig ausgebildet werden. Die Ausbildung von flächigen Elektroden ermöglicht außerdem eine großflächige Kontaktierung der Schwingungselemente, welche vorzugsweise als Piezoelemente ausgebildet sind.

Bevorzugt wird entsprechend ein Verfahren zum Herstellen einer solchen Mehrfachelektrode mit den Schritten des Trennens einer Elektrodenstruktur aus einem flächigen Metall, wobei ein Verbindungsleiter zwischen zwei Elektroden ausgebildet wird, und des Biegens des Verbindungsleiters derart, dass die Elektroden mit einem vorgegebenen Abstand zueinander parallel angeordnet werden. Ein solches Verfahren ermöglicht somit aus einem flächig gefertigten, beispielsweise gestanzten Metallelement mit einer Vielzahl einstückig verbundener Elektroden und Verbindungsleitern auf einfache Art und Weise eine Mehrfachelektrode zu biegen und zugleich die einzelnen Elektroden der Mehrfachelektrode miteinander zu verbinden, ohne dass separate Verbindungsleiter bereitgestellt und befestigt werden müssen.

Vorteilhafte Ausgestaltungen sind Gegenstand abhängiger Ansprüche.

Bevorzugt wird eine Mehrfachelektrode, bei welcher der Metallabschnitt aus einem flächigen, bogenförmigen Metall gefertigt ist. Die Gesamtanordnung kann somit mit einem einzigen Herstellungsschritt einschließlich zusammenhängender Elektroden und Verbindungsleiter gefertigt werden, insbesondere gestanzt, geätzt oder ausgeschnitten werden.

Bevorzugt wird eine Mehrfachelektrode, bei der die Elektroden längs einer Längsachse angeordnet sind und der Verbindungsleiter in abgewickelter Darstellung die Elektroden seitlich zu der Längsachse um einen Versatz versetzt miteinander verbindet. Ein solcher seitlicher Versatz ermöglicht auf besonders einfache Art und Weise eine spätere Verschachtelung zweier solcher Mehrfachelektroden ineinander, wobei durch den Versatz die jeweiligen Verbindungsleiter der beiden verschiedenen Mehrfachelektroden problemlos nebeneinander ohne Berührungen angeordnet werden können.

Bevorzugt wird gemäß einer zweiten Ausführungsform eine Mehrfachelektrode, bei der in abgewickelter Darstellung die Elektroden der Längsachse hintereinander und der Verbindungsleiter parallel zur Längsachse und seitlich neben den Elektroden angeordnet ist und wobei die Elektroden über jeweils einen Verbindungssteg mit dem Verbindungsleiter einstückig verbunden sind. Bevorzugt wird dabei eine Mehrfachelektrode, bei welcher die Verbindungsstege in Endstruktur der Mehrfachelektrode in einer Ebene der parallel zueinander verbundenen und angeordneten Elektroden angeordnet sind. Ausgebildet wird dadurch eine Mehrfachelektrode mit einzelnen einstückig mit einem einzigen Verbindungsleiter verbundenen Elektroden, wobei die Anordnung in Endstruktur einem Stiel mit ein- oder beidseitig seitlich abstehenden einzelnen Elektroden vergleichbar ausgebildet wird.

Gemäß einer besonders bevorzugten ersten Ausführungsform wird bevorzugt eine Mehrfachelektrode, bei der in abgewickelter Darstellung die Elektroden und der Verbindungsleiter in einer flächigen Ebene mit dem Verbindungsleiter zwischen den Elektroden hintereinander angeordnet sind. Dabei wird bevorzugt eine Mehrfachelektrode, bei der die beiden Elektroden in Endstruktur parallel zueinander angeordnet sind und bei welcher der Verbindungsleiter bogenförmig zwischen diesen verläuft. Besonders vorteilhaft ist dabei eine Mehrfachelektrode mit einer dritten Elektrode, welche über einen zweiten Verbindungsleiter mit einer zweiten der Elektroden verbunden ist, wobei der zweite Verbindungsleiter in Endstruktur relativ zur Längsachse der Endstruktur auf der gegenüberliegenden Seite des ersten Verbindungsleiters angeordnet ist. Eine Mehrfachelektrode gemäß dieser Ausführungsform verläuft somit in der Endstruktur schlangenförmig um und längs einer zentralen Längsachse durch die Mehrfachelektrode hindurch. Vorteilhafterweise kann durch den Biegevorgang auch eine Nachjustierung des Abstands der einzelnen zueinander benachbart angeordneten Elektroden von einem minimalen Abstandsmaß bis zu einem Abstandsmaß entsprechend der Länge der einzelnen Verbindungsleiter zwischen den einzelnen Elektroden ausgebildet werden.

Bevorzugt wird eine Mehrfachelektrode, bei der die Elektroden jeweils eine zentrale Öffnung aufweisen und diese Öffnungen der Elektroden in Endstruktur längs einer gemeinsamen Längsachse angeordnet sind.

Bevorzugt wird insbesondere eine Elektrodenanordnung mit zwei solchen Mehrfachelektroden aus jeweils zumindest zwei Elektroden, wobei die Elektroden jeweils parallel zueinander längs einer Längsachse zueinander angeordnet sind und wobei jeweils eine der Elektroden der einen Mehrfachelektrode zwischen zweien der Elektroden der anderen Mehrfachelektrode angeordnet ist, wobei die Verbindungsleiter der beiden Mehrfachelektroden jeweils in einer Ebene mit einer Ebenen-Längsachse längs oder parallel der Längsachse der Elektrodenanordnung angeordnet sind und die Ebenen um die Längsachse um einen Winkel zueinander verschwenkt oder gegenüber der Längsachse um einen Versatz versetzt angeordnet sind: Die beiden Ebenen, welche durch die Verbindungsleiter jeweils einer Mehrfachelektrode ausgebildet werden, werden somit gemäß einer Ausführungsvariante zueinander um einen Winkel verschwenkt, so dass die Verbindungsleiter einander nicht berühren können.

Gemäß der anderen Ausführungsvariante werden die beiden Ebenen der Verbindungsleiter seitlich zueinander, insbesondere parallel seitlich zueinander versetzt, so dass die Verbindungsleiter der verschiedenen Mehrfachelektroden einander nicht berühren und trotzdem seitlich aus der Gesamtanordnung herausragen und die entsprechenden Elektroden kontaktieren können.

Bevorzugt wird insbesondere eine Schwingungserzeugungs- und/oder Schwingungserfassungsvorrichtung mit zwei Elektroden als eine solche Mehrfachelektrode und zumindest einer Gegen-Elektrode zwischen den Elektroden, wobei die beiden Elektroden über einen diese seitlich verbindenden Verbindungsleiter miteinander verbunden sind, und Schwingungselementen zwischen jeweils benachbarten der Elektroden und der zumindest einen Gegen-Elektrode, wobei die beiden Elektroden und der Verbindungsleiter als Mehrfachelektrode aus einem einstückigen Metallabschnitt bzw. Metallbogen ausgebildet sind.

Vorteilhafterweise ist eine solche Schwingungserzeugungs- und/oder Schwingungserfassungsvorrichtung mit einer zentralen Öffnung durch die Elektroden und Schwingungselemente und mit einem durch die Öffnungen geführten Verbindungselement ausgestattet. Dabei weist das Verbindungselement vorteilhafterweise eine zentrale Durchgangsöffnung auf. Dies ermöglicht einen zentralen Zugriff durch die gesamte Anordnung hindurch auf einen Körper, von dem Schwingungen erfasst werden bzw. auf den erzeugte Schwingungen übertragen werden.

Ein Ausführungsbeispiel wird nachfolgend anhand der Zeichnung näher erläutert. Es zeigen:
- Fig. 1: eine Schwingungserzeugungs- und Schwingungserfassungsvorrichtung mit einer Anordnung mehrerer Mehrfachelektroden;
- Fig. 2: eine Mehrfachelektrode gemäß Fig. 1 in abgewickelter Darstellung;
- Fig. 3: die Mehrfachelektrode gemäß Fig. 2 in Darstellung der Endstruktur; und
- Fig. 4A, 4B: eine Mehrfachelektrode in abgewickelter Darstellung bzw. in Endstruktur gemäß einer weiteren Ausführungsform.

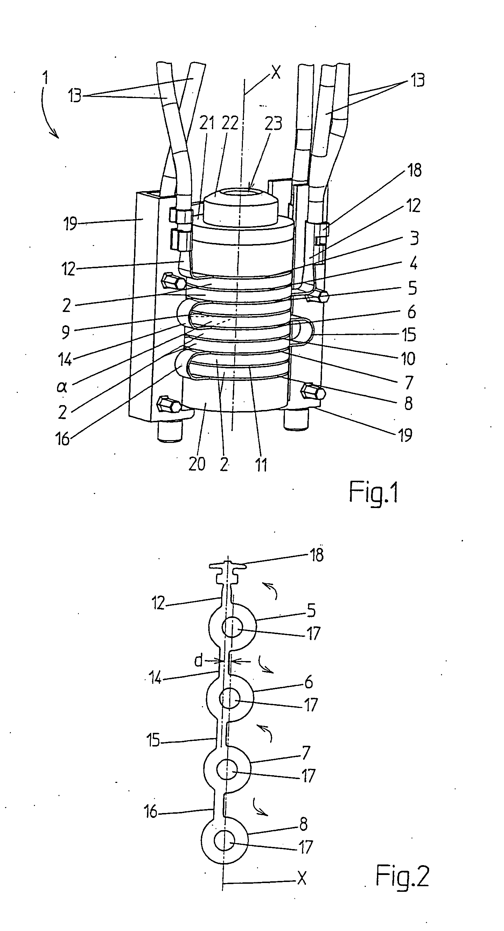

Fig. 1 zeigt eine Schwingungserzeugungs- und Schwingungserfassungsvorrichtung 1 mit einer Vielzahl von Schwingungselementen und dazwischen geschalteten Elektroden und Gegen-Elektroden. Eine solche Vorrichtung kann als reine Schwingungserzeugungsvorrichtung, als eine Schwingungserfassungsvorrichtung oder als kombinierte Schwingungserzeugungs- und Schwingungserfassungsvorrichtung geschaltet werden. Insbesondere ist die Anzahl von einzelnen Schwingungselementen 2, vorzugsweise piezokeramischen Schwingungselementen, sowie deren Beschaltung auch in verschiedenen anderen Anordnungen möglich. Die dargestellte Gesamtanordnung erstreckt sich in Längsrichtung zylindrisch um eine Längsachse X. Prinzipiell sind aber auch andere Querschnittsformen umsetzbar.

Bei der besonders bevorzugten Ausführungsform weist die Schwingungserzeugungs- und Schwingungserfassungsvorrichtung 1 eine Vielzahl von Schwingungselementen 2 auf. Die Schwingungselemente 2, vorzugsweise piezokeramische Elemente, sind scheibenförmig mit ihren Stirnflächen übereinander angeordnet und erstrecken sich kreisförmig um die Längsachse X. Zwischen jeweils zweien der Schwingungselemente 2 sowie außenseitig an dem durch die Schwingungselemente 2 gebildeten Stapel ist jeweils eine Elektrode 3, 5 - 8 oder Gegen-Elektrode 4, 9 - 11 angeordnet. Der erste Block aus Schwingungselementen 2 zwischen den ersten Elektroden 3, 5 und der ersten Gegen-Elektrode 4 bildet beispielsweise eine Schwingungserfassungseinheit zum Erfassen von Schwingungen aus, welche auf die Gesamtvorrichtung übertragen werden. Die zweite Baugruppe aus den weiteren Schwingungselementen 2 und Elektroden 5 - 8 bzw. Gegen-Elektroden 9 - 11 bildet beispielsweise eine Schwingungserzeugungseinheit zum Erzeugen von Schwingungen aus, welche auf eine stirnseitig angeordnete und nicht dargestellte Einheit zu übertragen sind. Diese zweite Gruppe besteht somit aus einer Vielzahl von Schwingungselementen 2, von denen jedes zweite Schwingungselement 2 auf einer Seite mit einer Elektrode 5 - 8 auf jeweils gleichem Potential zu beschalten ist. Die Vielzahl dieser einzelnen Elektroden 5 - 8 bildet somit aufgrund von zwischen diesen angeordneten Verbindungsleitern 14 - 16 eine Mehrfachelektrode aus. Die jeweils andere Seite dieser Gruppe von Schwingungselementen 2 wird entsprechend mit Gegen-Elektroden 9 - 11 beschaltet, welche ebenfalls auf einem gemeinsamen Potential liegen und durch entsprechende Verbindungsleiter miteinander verbunden sind. Die Verbindungsleiter der Gegen-Elektroden 9 - 11 verlaufen beim dargestellten Ausführungsbeispiel innerhalb von zwei seitlich der Gesamtanordnung angeordneten Führungs- und Befestigungselementen 19 und sind daher nicht dargestellt. Im Wesentlichen entspricht die zweite Mehrfachelektrode, welche durch die Gegen-Elektroden 9 - 11 und deren Verbindungsleiter ausgebildet wird, dem Aufbau der ersten Mehrfachelektrode 24, welche durch die Elektroden 5 - 8 und deren Verbindungsleiter 14 - 16 ausgebildet wird.

Die jeweils erste Elektrode 5, 9 einer solchen Gruppe aus Mehrfachelektroden bzw. auch einzelne Elektroden 3, 4 weisen jeweils einen Anschlussleiter 12 auf, an dem ein Kabel 13 über beispielsweise einen Klemmabschnitt 18 zum Zu- bzw. Abführen von Spannungen und Strömen angeschlossen ist.

Die gesamte Anordnung aus Schwingungselementen 2, Elektroden 3, 5 - 8 und Gegen-Elektroden 4, 9 - 11 wird vorzugsweise über eine Verspannungseinrichtung zusammengespannt. Die Verspannungseinrichtung besteht beim dargestellten Ausführungsbeispiel aus einem ersten Spann- und Schwingungsübertragungselement 20 sowie jenseits der Schwingungselemente einem Zwischenstück und einem zweiten Spannelement 21, welches über beispielsweise einen Spannbolzen 22 oder eine Spannschraube gegeneinander verspannt werden. Der dargestellte Spannbolzen 22 führt durch eine zentrale Öffnung 17, welche durch die Gesamtanordnung aus Spann- und Schwingungsübertragungselement, Elektroden 3, 5 - 8, Gegen-Elektroden 4, 9 - 11, Schwingungselementen 2, Zwischenelement und Spannelement 21 hindurchführt. Auf diese Art und Weise ist eine zentrale Verspannung längs der gemeinsamen Längsachse X als Haupt-Schwingungsachse vorteilhaft möglich. Bei dem dargestellten Ausführungsbeispiel weist der zentral durch die Anordnung geführte Spannbolzen 22 eine hindurchführende Durchgangs- bzw. Zugriffsöffnung 23 auf, so dass ein zentraler Durchgriff auf Komponenten und Einrichtungen möglich ist, auf denen die Schwingungserzeugungs- und Schwingungserfassungsvorrichtung 1 montiert ist. Alternativ können jedoch auch andere für sich bekannte Anordnungen zum Befestigen der einzelnen Schwingungselemente 2 und Elektroden und Gegen-Elektroden 3 - 11 aneinander verwendet werden.

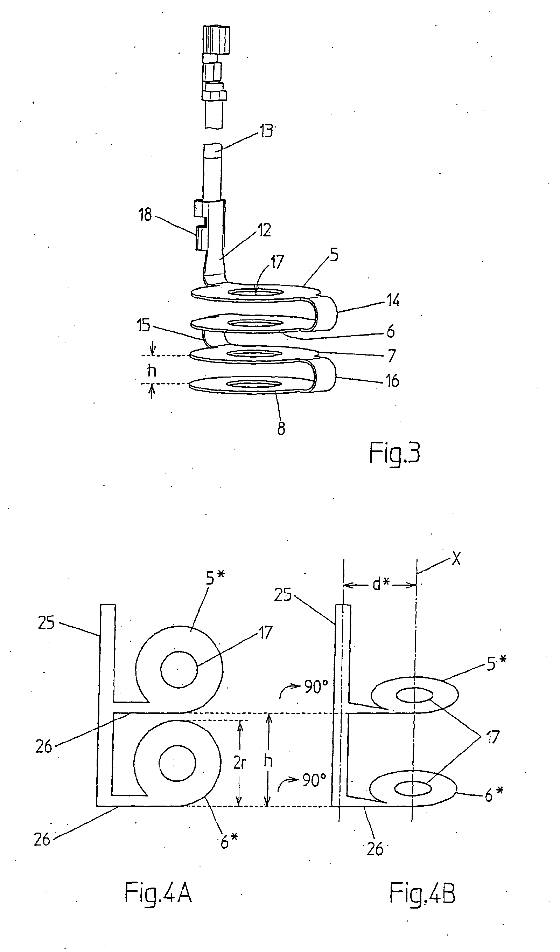

Fig. 2 und 3 zeigen eine besonders bevorzugte Ausgestaltung der ersten Mehrfachelektrode 24. Fig. 2 zeigt die erste Mehrfachelektrode 24 gemäß einem ersten Verfahrensschritt einen Verfahrens zum Herstellen einer solchen Mehrfachelektrode. Die erste Mehrfachelektrode 24 besteht dabei aus einem flächigen und einstückigen Bauelement, welches aus einem flächigen Metallbogen bzw. elektrisch leitenden Material gefertigt wird. Die Fertigung kann beispielsweise durch Ausstanzen, Ausätzen oder Ausschneiden erfolgen. Die Mehrfachelektrode 24 besteht dabei aus einer hintereinander in Reihe angeordneten Abfolge der Elektroden 5 - 8. Jeweils zwei benachbarte der Elektroden 5 - 6, 6 - 7, 7 - 8 sind über den zwischen ihnen ausgebildeten Verbindungsleiter 14, 15 bzw. 16 einteilig miteinander verbunden. Die erste Elektrode 5 weist außerdem einen Anschlussleiter 12 auf, der gemäß der dargestellten Ausführungsform mit Laschen zum Ausbilden eines Klemmabschnitts 18 ausgebildet ist.

Gemäß der besonders bevorzugten Ausführungsform sind die einzelnen der Verbindungsleiter 14 - 16 und der Anschlussleiter 12 parallel zu einer zentralen Längsachse X sowie seitlich um einen Versatz d von der Längsachse X versetzt zwischen den einzelnen Elektroden 5 - 8 ausgebildet. Wird die zweite Mehrfachelektrode mit Verbindungsleitern ausgebildet, welche entsprechend zur gegenüberliegenden Seite der Längsachse X versetzt ausgebildet sind, so können die beiden Mehrfachelektroden mit den einzelnen Elektroden bzw. Gegen-Elektroden zwischeneinander angeordnet werden, wobei die einzelnen Verbindungsleiter der beiden Mehrfachelektroden nebeneinander verlaufend seitlich aus dem Stapel der Schwingungselemente 2 und Elektroden 5 - 8 bzw. Gegen-Elektroden 9 - 11 herausragen, ohne einander zu behindern.

Fig. 3 zeigt einen zweiten Verfahrensschritt des Verfahrens zum Herstellen einer solchen Mehrfachelektrode 24. Ausgehend von einem Ende der Mehrfachelektrode 24 werden die einzelnen Verbindungsleiter 14 - 16 jeweils so gebogen, dass die beiden benachbarten Elektroden 5 - 6, 6 - 7, 7 - 8 parallel zueinander mit einem Abstand h der jeweils gleich gepolten Elektroden 5 - 8 angeordnet werden. Neben der Möglichkeit, winklige Verbiegungen der Verbindungsleiter 14 - 16 vorzunehmen, werden gleichmäßig gebogene Verbindungsleiter 14 - 16 besonders bevorzugt.

Zwei Mehrfachelektroden als Anordnung von Elektroden 5 - 8 und dazwischen befindlichen Gegen-Elektroden 9 - 11 werden derart ineinander eingesetzt, dass zwischen jeweils zwei Elektroden 5 - 6, 6 - 7, 7 - 8 eine Gegen-Elektrode 9, 10 bzw. 11 angeordnet ist. Die Verbindungsleiter 14 - 16 und der Anschlussleiter 12 der ersten derart ausgebildeten Mehrfachelektrode 24 werden dabei so ausgerichtet, dass diese in einer ersten Ebene verlaufen, deren eine Längsachse mit der Längsachse X der Elektrodenanordnung eine gemeinsame Schnittlinie ausbildet oder parallel dazu verläuft. Die zweite Mehrfachelektrode mit den Gegen-Elektroden und diese verbindenden Verbindungsleitern wird entsprechend ausgerichtet, wobei jedoch die Ebenen der beiden Mehrfachelektroden hinsichtlich deren Verbindungsleitern um die Längsachse X um einen Winkel α zueinander verschwenkt oder seitlich dazu versetzt angeordnet sind. Bei der in Fig. 1 dargestellten Ausführungsform verlaufen die Verbindungsleiter 14 - 16 der ersten Mehrfachelektrode 24 in einer Ebene seitlich versetzt zur Längsachse X vor den dargestellten Führungs- und Befestigungselementen 19. Die Verbindungsleiter der zweiten Mehrfachelektrode verlaufen nicht dargestellt in einer zweiten Ebene durch die Längsachse X oder ebenfalls parallel zu der Längsachse X versetzt in oder hinter den Führungs- und Befestigungselementen 19.

Um die Verspannungsvorrichtung gemäß Fig. 1 zu ermöglichen, weisen die einzelnen Elektroden 5 - 8, wie in den Fig. 2 und 3 dargestellt, eine jeweils zentrale Öffnung 17 zum Durchführen von Befestigungselementen und dergleichen auf.

Gemäß einer zweiten Ausführungsform ist wiederum eine Vielzahl von Elektroden 5*, 6* an einem Verbindungsleiter 25 einstückig angeordnet ausgebildet. Der Verbindungsleiter 25 verläuft jedoch parallel neben den einzelnen Elektroden 5*, 6*, wobei die einzelnen Elektroden 5*, 6* jeweils über einen Verbindungsabschnitt bzw. Verbindungssteg 26 einstückig mit dem in diesem Fall einzigen Verbindungsleiter 25 verbunden und ausgebildet sind. Der Abstand der einzelnen Verbindungsstege 26 entspricht dabei dem Abstand h der Elektroden in der Endstruktur, nachdem die Elektroden 5*, 6* jeweils um 90° umgebogen wurden (Fig. 4B). Diese Ausführungsform bietet den Vorteil, trotz einer einstückigen Ausbildung der einzelnen Elektroden 5*, 6* und des Verbindungsleiters 25, 26 auf einfache Art und Weise die Elektroden 5*, 6* in die gewünschte Endlage zu verbringen und im Fall von ineinander verschachtelten Mehrfachelektroden die beiden entsprechenden Verbindungsleiter nebeneinander oder gegenüberliegend beliebig anordnen zu können, ohne spezielle Winkel- oder Versatzvorgaben zu berücksichtigen. Jedoch sind gemäß der einfachsten Ausgestaltung der zweiten Ausführungsform die Abstände h der Elektroden 5*, 6* von der Breite bzw. dem Radius r der einzelnen Elektroden 5*, 6* abhängig. Bei zweiseitiger Anordnung der Elektroden am Verbindungsleiter halbiert sich dieser Abstand.

## Patentansprüche

1. Mehrfachelektrode (24) für eine Schwingungserzeugungs- und/oder Schwingungserfassungsvorrichtung (1) mit zumindest zwei Elektroden (5, 6; 5*, 6*) und einem diese verbindenden Verbindungsleiter (14; 25, 26), wobei die beiden Elektroden (5, 6; 5*, 6*) parallel mit einem Abstand (h) zueinander angeordnet sind,
**dadurch gekennzeichnet , dass**
die beiden Elektroden (5, 6; 5*, 6*) und der Verbindungsleiter (14; 25, 26) aus einem einteiligen Metallabschnitt ausgebildet sind.

2. Mehrfachelektrode nach Anspruch 1, wobei der Metallabschnitt aus einem flächigen, bogenförmigen Metall gefertigt ist.

3. Mehrfachelektrode nach Anspruch 1 oder 2, wobei die Elektroden (5, 6; 5*, 6*) längs einer Längsachse (X) angeordnet sind und der Verbindungsleiter (14; 25) in abgewickelter Darstellung die Elektroden (5, 6; 5*, 6*) seitlich zu der Längsachse (X) um einen Versatz (d; d*) versetzt miteinander verbindet.

4. Mehrfachelektrode nach einem vorstehenden Anspruch, wobei in abgewickelter Darstellung die Elektroden (5*, 6*) der Längsachse (X) hintereinander und der Verbindungsleiter (25) parallel zur Längsachse (X) und seitlich neben den Elektroden (5*, 6*) angeordnet ist und wobei die Elektroden über jeweils einen Verbindungssteg (26) mit dem Verbindungsleiter (25) einstückig verbunden sind.

5. Mehrfachelektrode nach Anspruch 4, bei welcher die Verbindungsstege (26) in Endstruktur der Mehrfachelektrode in einer Ebene der parallel zueinander verbundenen und angeordneten Elektroden (5*, 6*) angeordnet sind.

6. Mehrfachelektrode nach einem der Ansprüche 1 - 4, wobei in abgewickelter Darstellung die Elektroden (5, 6) und der Verbindungsleiter (14) in einer flächigen Ebene mit dem Verbindungsleiter (14) zwischen den Elektroden (5, 6) hintereinander angeordnet sind.

7. Mehrfachelektrode nach Anspruch 6, bei der die beiden Elektroden (5, 6) in Endstruktur parallel zueinander angeordnet sind und der Verbindungsleiter (14) bogenförmig zwischen diesen verläuft.

8. Mehrfachelektrode nach Anspruch 6 oder 7 mit einer dritten Elektrode (7), welche über einen zweiten Verbindungsleiter (15) mit einer zweiten der Elektroden (6) verbunden ist, wobei der zweite Verbindungsleiter (15) in Endstruktur relativ zur Längsachse (X) der Endstruktur auf der gegenüberliegenden Seite des ersten Verbindungsleiters (14) angeordnet ist.

9. Mehrfachelektrode nach einem vorstehenden Anspruch, bei der die Elektroden (5, 6; 5*, 6*) jeweils eine zentrale Öffnung (17) aufweisen und diese Öffnungen (17) der Elektroden in Endstruktur längs einer gemeinsamen Längsachse (X) angeordnet sind.

10. Elektrodenanordnung mit zwei Mehrfachelektroden nach einem der Ansprüche 1 - 9 aus jeweils zumindest zwei Elektroden (5 - 8 bzw. 9 - 11), wobei die Elektroden jeweils parallel zueinander längs einer Längsachse (X) zueinander angeordnet sind und wobei jeweils eine der Elektroden (9 - 11) der einen Mehrfachelektrode zwischen zweien der Elektroden (5 - 8) der anderen Mehrfachelektrode (24) angeordnet ist, wobei die Verbindungsleiter (14 - 16) der beiden Mehrfachelektroden jeweils in einer Ebene mit einer Ebenen-Längsachse längs oder parallel der Längsachse (X) der Elektrodenanordnung angeordnet sind und die Ebenen um die Längsachse um einen Winkel
(α) zueinander verschwenkt oder gegenüber der Längsachse um einen Versatz (d) versetzt angeordnet sind.

11. Füllstandmessgerät (1) mit
- zwei Elektroden (5, 6) als Mehrfachelektrode (24), wobei die beiden Elektroden (5, 6) über einen diese seitlich verbindenden Verbindungsleiter (14) miteinander verbunden sind,
- zumindest einer Gegen-Elektrode (9) zwischen den Elektroden (5, 6) und
- Schwingungselementen (2) zwischen jeweils benachbarten der Elektroden (5, 6) und der zumindest einen Gegen-Elektrode (9),
**dadurch gekennzeichnet, dass**
- die beiden Elektroden (5, 6) und der Verbindungsleiter (14) als Mehrfachelektrode nach einem vorstehenden Anspruch aus einem einstückigen Metallabschnitt ausgebildet sind.

12. Füllstandmessgerät nach Anspruch 11 mit einer zentralen Öffnung (17) durch die Elektroden (5, 6, 9) und Schwingungselemente (2) und mit einem durch die Öffnungen (17) geführten Verbindungselement (22).

13. Füllstandmessgerät nach Anspruch 12, wobei das Verbindungselement (22) eine zentrale Durchgangsöffnung (23) aufweist.

14. Verfahren zum Herstellen einer Mehrfachelektrode nach einem vorstehenden Anspruch mit den Schritten:
- Trennen einer Elektrodenstruktur aus einem flächigen Metall, wobei ein Verbindungsleiter (14 - 16) zwischen zwei Elektroden (5 - 6, 6 - 7, 7 - 8) ausgebildet wird und
- Biegen des Verbindungsleiters (14 - 16) derart, dass die Elektroden (5 - 8) mit einem vorgegebenen Abstand (h) zueinander parallel angeordnet werden.
